Europäisches Patentamt

European Patent Office

Office européen des brevets

(19)

(11) Veröffentlichungsnummer : **0 551 906 B1**

## (12) EUROPÄISCHE PATENTSCHRIFT

(45) Veröffentlichungstag der Patentschrift :
25.10.95 Patentblatt 95/43

(51) Int. Cl.⁶ : **G05F 3/26, H03K 17/10**

(21) Anmeldenummer : **93100496.4**

(22) Anmeldetag : **14.01.93**

(54) **Schaltbarer MOS-Stromspiegel.**

(30) Priorität : **17.01.92 DE 4201155**

(43) Veröffentlichungstag der Anmeldung :
**21.07.93 Patentblatt 93/29**

(45) Bekanntmachung des Hinweises auf die
Patenterteilung :
**25.10.95 Patentblatt 95/43**

(84) Benannte Vertragsstaaten :
**FR GB IT NL**

(56) Entgegenhaltungen :
**EP-A- 0 060 336
EP-A- 0 212 833
EP-A- 0 378 453
US-A- 4 544 878**

(73) Patentinhaber : **TEXAS INSTRUMENTS
DEUTSCHLAND GMBH
Haggertystrasse 1
D-85356 Freising (DE)**

(72) Erfinder : **Bayer, Erich
Am Blankenfeld 15
W-8300 Ergolding (DE)**

(74) Vertreter : **Schwepfinger, Karl-Heinz, Dipl.-Ing.
Prinz & Partner,
Manzingerweg 7
D-81241 München (DE)**

**Beschreibung**

Die vorliegende Erfindung betrifft einen schaltbaren MOS-Stromspiegel, wie er im Oberbegriff des Patentanspruchs 1 definiert ist.

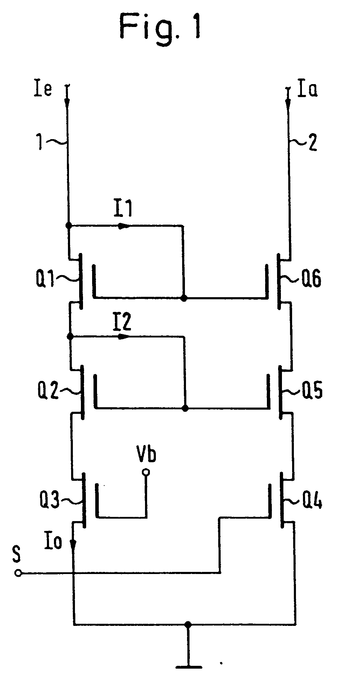

In integrierten MOS-Schaltungen werden Stromspiegel benötigt, um Schaltungen mittels Strömen anzusteuern, deren Beträge genau festgelegt sind. Figur 1 zeigt einen bekannten MOS-Stromspiegel mit einem ersten Stromzweig, durch den ein im wesentlichen konstanter Strom Ie fließt, und einem zweiten Stromzweig, über den ein Ausgangsstrom Ia ausgegeben wird, wenn an einem Anschluß S des MOS-Stromspiegels ein Steuersignal anliegt. Der erste und der zweite Stromzweig weist jeweils drei in Kaskadenschaltung liegende MOS-Feldeffekttransistoren, Q1, Q2 und Q3 bzw. Q4, Q5 und Q6, auf. Der Eingangsstrom Ie wird dem MOS-Feldeffekttransistor Q1 über dessen Drain-Elektrode zugeführt, während der Ausgangsstrom Ia über die Drain-Elektrode des MOS-Feldeffekttransistors Q6 ausgegeben wird. Die Gate-Elektroden der MOS-Feldeffekttransistoren Q1 und Q6 sind mit der Drain-Elektrode des MOS-Feldeffekttransistors Q1 verbunden. Die Gate-Elektroden der MOS- Feldeffekttransistoren Q2 und Q5 sind an der Source-Elektrode des Transistors Q1 angeschlossen, während die Drain-Elektroden der Transistoren Q2 und Q5 mit den Source-Elektroden der Transistoren Q1 bzw. Q6 verbunden sind. Die Gate-Elektroden der MOS-Feldeffekttransistoren Q3 und Q4 sind an eine Betriebsspannung Vb bzw. an den Anschluß S angeschlossen.

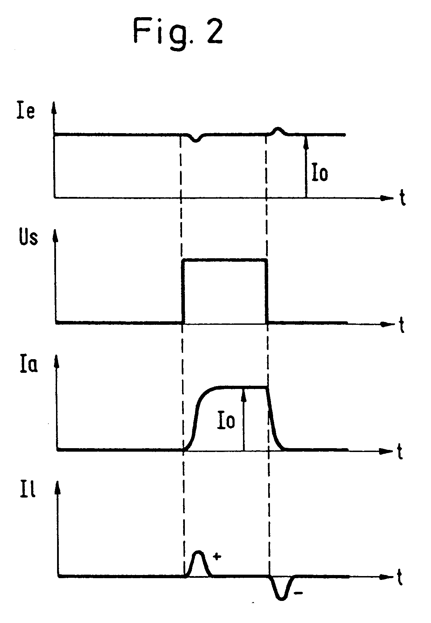

Die Arbeitsweise eines derartigen Stromspiegels läßt sich anhand der Zeitdiagramme aus Figur 2 erläutern. Das erste Zeitdiagramm (erstes Diagramm) zeigt den zeitlichen Verlauf des Eingangsstromes Ie. Wird dem Stromspiegel über den Anschluß S ein Steuersignal Us zugeführt (siehe zweites Zeitdiagramm), so öffnet der Transistor Q4 des zweiten Stromzweiges, so daß sich die Gate-Source-Spannung an den Transistoren Q5 und Q6 ändert. Dies hat unmittelbar das Fließen von Ladeströmen I1 und I2 in die Gate-Kapazitäten dieser beiden Transistoren zur Folge. Diese Ladeströme werden vom Eingangsstrom Ie abgezweigt, so daß nicht mehr der volle Eingangsstrom Ie zur Spiegelung zur Verfügung steht. Der Ausgangsstrom Ia entspricht also während der Zeit des Fließens der Ladeströme nicht dem ursprünglichen Eingangsstrom Ie, sondern ist um die Summe der Ladeströme niedriger als der dem Eingangsstrom entsprechende Sollwert Io. Die Folge ist eine deutliche Verlangsamung der Anstiegsflanke des Ausgangsstroms Ia. Im vierten Diagramm aus Fig. 2 ist der zeitliche Verlauf der Ladeströme dargestellt. Der Ausgangsstrom Ia, dessen zeitlicher Verlauf im dritten Diagramm aus Figur 2 gezeigt ist, steigt allmählich an bis der Sollwert Io erreicht wird. Der Ausgangsstrom behält seinen Sollwert Io bei, solange das Steuersignal im H-Zustand ist. Wie aus dem zweiten und dritten Zeitdiagramm ersichtlich, wird der Ausgangsstrom Ia abgeschaltet, sobald das Steuersignal in den L-Zustand übergeht.

Dieser MOS-Stromspiegel weist zwar im Gleichstrom-Betrieb eine hohe Genauigkeit auf, diese nimmt jedoch erheblich ab, wenn die der Steuersignalfrequenz entsprechende Schaltfrequenz zunimmt, da der Eingangsstrom infolge der Ladeströme unter seinen Sollwert sinkt, und da infolge der Ladeströme die Anstiegszeit des Ausgangsstromes erheblich verlängert wird, so daß der Ausgangsstrom Ia den Sollwert Io bei höheren Schaltfrequenzen innerhalb der Schaltperiode nicht mehr erreicht. Darüber hinaus führt der vom Eingangsstrom Ie abgezweigte Ladestrom I1 zu unsauberen Anstiegs- und Abstiegsflanken des Ausgangsstroms, was sich bei hohen Schaltfrequenzen störend auf den Betrieb einer durch den Stromspiegel angesteuerten Schaltung auswirkt.

Aus der EP-A-0 212 833 ist ein geschalteter Stromspiegel bekannt, bei dem die oben geschilderte Erscheinung auftritt, daß der Ausgangsstrom während der Zeit des Fließens der Ladeströme nicht dem ursprünglichen Eingangsstrom entspricht, sondern um die Summe der Ladeströme niedriger als der Eingangsstrom ist. Zur Beseitigung dieses Problems sind bei dem bekannten geschalteten Stromspiegel keine besonderen Maßnahmen getroffen, so daß sich die geschilderten Nachteile hinsichtlich des Betriebs bei hohen Schaltfrequenzen ergeben.

Daher ist es Aufgabe der vorliegenden Erfindung, einen schaltbaren MOS-Stromspiegel zu schaffen, der auch bei hohen Schaltfrequenzen einen Ausgangsstrom liefert, der dem Sollwert des Eingangsstrom mit hoher Genauigkeit entspricht. Diese Aufgabe wird bei einem schaltbaren MOS-Stromspiegel der oben geschilderten Art mit den Merkmalen des kennzeichnenden Teils des Patentanspruchs 1 gelöst.

Im Unteranspruch 2 ist angegeben, wie der erfindungsgemäße MOS-Stromspiegel zum Ansteuern einer Schaltung verwendet wird.

Bei einem erfindungsgemäßen MOS-Stromspiegel werden die Ladeströme der Gate-Kondensatoren der MOS-Feldeffekttransistoren beider Stromzweige von den Ladungsspeicherkondensatoren geliefert, so daß keine Abzweigung der Ladeströme vom Eingangsstrom mehr erfolgt. Der Ausgangsstrom entspricht daher auch bei hohen Schaltfrequenzen genau dem Eingangsstrom.

Im folgenden werden Ausführungsbeispiele der vorliegenden Erfindung anhand der Zeichnungen beschrieben. Es zeigen:

Figur 1 das Schaltbild eines herkömmlichen MOS-Stromspiegels,

Figur 2 Zeitdiagramme zur Erläuterung der Arbeitsweise des MOS-Stromspiegels aus Figur 1,

Figur 3 ein erstes Ausführungsbeispiel der Erfindung,

Figur 4 Zeitdiagramme zur Erläuterung der Arbeitsweise des ersten Ausführungsbeispieles,

Figur 5 ein zweites Ausführungsbeispiel der vorliegenden Erfindung.

Figur 1 und 2 zeigt den Schaltplan bzw. die zur Erläuterung der Funktionsweise notwendigen Zeitdiagramme des in der Beschreibungseinleitung beschriebenen MOS-Stromspiegels.

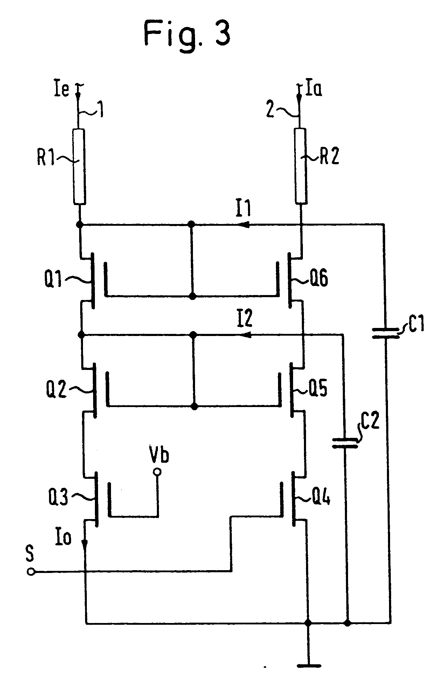

Das in Figur 3 abgebildete Ausführungsbeispiel zeigt einen schaltbaren MOS-Stromspiegel einer integrierten Schaltung mit einem Eingangsstromzweig 1, durch den ein Eingangsstrom Ie fließt und der einen ersten und zweiten MOS-Feldeffekttransistor (Q1, Q2) aufweist, und mit einem Ausgangsstromzweig 2, der einen fünften und sechsten MOS-Feldeffekttransistor (Q5, Q6) aufweist und über den ein Ausgangsstrom Ia ausgegeben wird, wenn an einem Anschluß S des MOS-Spiegels ein Steuersignal anliegt. Beide Stromzweige sind über die Drain-Source-Strecken eines dritten und eines vierten MOS-Feldeffekttransistors (Q3, Q4), die beide in einem Schaltteil des Stromspiegels angeordnet sind, an Masse angeschlossen. Die Drain-Source-Strecken des Eingangs- und des Ausgangsstromzweiges (1, 2) liegen jeweils in Serienschaltung und sind mit einem ersten Widerstand R1 bzw. mit einem zweiten Widerstand R2 in Reihe geschaltet. Die Gate-Elektroden der mit den Widerständen R1 und R2 verbundenen MOS-Feldeffekttransistoren Q1 bzw. Q6 sind an den Verbindungspunkt zwischen dem ersten Feldeffekttransistor Q1 und dem ersten Widerstand R1 und über einen ersten Kondensator C1 an Masse angeschlossen. Die Gate-Elektroden der mit den Source-Elektroden des ersten und sechsten MOS-Feldeffekttransistors verbundenen MOS-Feldeffekttransistoren Q2 bzw. Q5 sind an den Verbindungspunkt zwischen dem ersten und dem zweiten MOS-Feldeffekttransistor (Q1 bzw. Q2) und über einen zweiten Kondensator C2 an Masse angeschlossen. Die Source-Elektroden der Transistoren Q2 und Q5 sind mit den Drain-Elektroden des dritten bzw. vierten MOS-Feldeffekttransistors (Q3, Q4) verbunden. Die Source-Elektroden des dritten und vierten MOS-Feldeffekttransistors, Q3 und Q4, liegen an Masse, während die Gate-Elektroden des dritten und vierten Feldeffekttransistors, Q3 und Q4, an Betriebspannung Vb bzw. an den Anschluß S angeschlossen sind, der zum Zuführen eines Steuersignales (Us) dient.

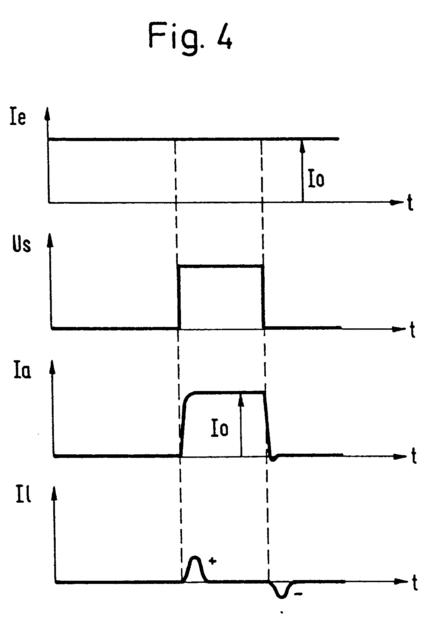

Im folgenden wird nun die Arbeitsweise des ersten Ausführungsbeispieles der Erfindung anhand der Zeitdiagramme aus Figur 4 beschrieben.

Schließt man den MOS-Stromspiegel an eine Stromquelle an, so werden die Kondensatoren C1 und C2 über ihre Verbindungsleiter zum ersten Stromzweig aufgeladen, bis die Kondensatoren im wesentlichen feste Spannungswerte U1 bzw. U2 erreichen. Nach dem Ladevorgang fließt dann ein konstanter Eingangsstrom Ie durch den ersten Stromzweig.

Wenn der MOS-Feldeffekttranssistor Q4 beim Anlegen eines Steuersignales Us (siehe zweites Diagramm aus Figur 4) geöffnet wird, so halten die Kondensatoren C1 und C2 die an den Gate-Elektroden der MOS-Feldeffekttransistoren Q5 und Q6 anliegenden Spannungen U1 und U2 im wesentlichen aufrecht, so daß kein Ladestrom aus dem ersten Stromzweig abgezweigt wird. Die Kondensatoren C1 und C2 wirken wie Akkumulatoren und liefern die zum Öffnen der Feldeffekttransistoren Q5 und Q6 erforderlichen, positiven Ladeströme I1 bzw. I2. Dadurch sinkt der Eingangsstrom Ie nicht unter einen vorbestimmten Sollwert Io, wenn nach Eingang des Steuersignales ein positiver Ladestrom I1 fließt der gleich I1+I2 ist (siehe erstes und viertes Zeitdiagramm aus Figur 4). Folglich gilt auch während des Ladevorgangs die Beziehung: Ie = Io.

Wenn der MOS-Feldeffekttransistor Q4 nach Wegfall des Spannungssignales sperrt, so kann die in den Gate-Elektroden der Feldeffekttransistoren Q5 und Q6 befindliche Ladung wieder abfließen, wobei ein negativer Ladestrom I1 in die Kondensatoren C1 und C2 fließt. Soll kein Ladungsstrom vom Eingangsstrom Ie abgezweigt wird, müssen die Kapazitäten (C) der Kondensatoren C1 und C2 einerseits genügend groß sein, damit beim Ladevorgang im wesentlichen keine Spannungsänderungen an den Kondensatoren und somit an den Gate-Elektroden auftreten. Die Spannungsänderung $\Delta U$ an den Gate-Elektroden der MOS-Feldeffekttransistoren Q5 und Q6 läßt sich quantitativ nach folgender Formel bestimmen:

$$\Delta U = \int Ig \; dt/C$$

Darin ist Ig der von oder zu der Gate-Elektrode fließende Strom und C die Kapazität der Kondensatoren C1 oder C2. In den meisten Anwendungsfällen reichen Kapazitäten von einigen pF aus. Die Kapazität C der Kondensatoren C1 und C2 darf andererseits eine bestimmte Obergrenze, die von der Dauer der Ausschaltezeiten $t_{OFF}$ abhängig ist, nicht überschreiten. Sind die Ausschaltzeiten (Zeitdauer, in der das Steuersignal Us im L-Zustand ist) kurz und die Kapazität C groß, so können sich die Kondensatoren C1 und C2 während der Ausschaltzeiten nicht wieder auf ihren ursprünglichen Wert aufladen. Die für die Aufladung der Kondensatoren C1 und C2 notwendige Ladezeit $t_L$ läßt sich quantitativ nach folgender Formel bestimmen:

$$t_L = C \cdot \Delta U / Ie$$

Folglich muß die kürzeste Ausschaltzeit länger als die Ladezeit $t_L$ sein, das heißt, daß folgende Bedingung erfüllt sein muß: $t_{OFF} > C \cdot \Delta U / Ie$

Der MOS-Stromspiegel aus Figur 3 weist gegenüber herkömmlicher Stromspiegel eine Reihe von Vorteilen auf: über die Kondensatoren C1 und C2 können, wie in Figur 4 gezeigt, nicht nur positive sondern auch negative Ladeströme geliefert werden; die Kondensatoren C1 und C2 liefern die erforderlichen Ladeströme, ohne daß die Laufzeit des MOS-Stromspiegels verlängert wird; die Anstiegszeit des Ausgangsstromes Ia ist, wie aus dem Vergleich der entsprechenden Zeitdiagramme aus Figur 2 und Figur 4 ersichtlich, gegenüber herkömmlicher MOS-Stromspiegel verkürzt, wodurch eine kürzere Schaltzeit gewährleistet ist.

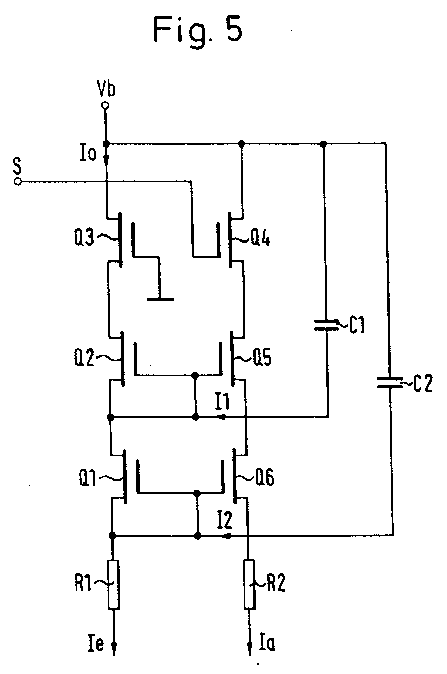

Das in Figur 5 beschriebene Ausführungsbeispiel zeigt einen schaltbaren MOS-Stromspiegel, dessen Eingangs- und Ausgangsstromzweig P-Kanal-MOS-Feldeffekttransistoren aufweisen. Die Arbeitsweise des zweiten Ausführungsbeispieles ist die gleiche wie die des anhand von Figur 4 beschriebenen MOS-Stromspiegels. Das in Figur 5 abgebildete Ausführungsbeispiel zeigt, daß die vorliegende Erfindung nicht nur für integrierte Schaltungen mit N-Kanal-Feldeffekttransistoren, sondern auch für intergrierte Schaltungen mit P-Kanal-Feldeffekttransistoren geeignet ist.

## Patentansprüche

1. Schaltbarer MOS-Stromspiegel mit einem Eingangsstromzweig (1) und einem Ausgangsstromzweig (2), wobei im Eingangsstromzweig (1) die Drain-Source-Strecken eines ersten und zweiten MOS-Feldeffekttransistors (Q1, Q2) in Serie geschaltet sind und im Ausgangsstromzweig (2) die Drain-Source-Strecken eines fünften und sechsten MOS-Feldeffekttransistors (Q5, Q6) in Serie geschaltet sind und wobei die Gate-Elektrode des ersten MOS-Feldeffekttransistors (Q1) mit dessen Drain-Elektrode und mit der Gate-Elektrode des sechsten MOS-Feldeffekttransistors (Q6) verbunden ist und die Gate-Elektrode des zweiten MOS-Feldeffekttransistors (Q2) mit dessen Drain-Elektrode und mit der Gate-Elektrode des fünften MOS-Feldeffekttransistors (Q5) verbunden ist, und mit einem Schaltteil, das einen dritten und einen vierten MOS-Feldeffekttransistor (Q3 bzw. Q4) aufweist, deren Gate-Elektroden jeweils an eine Betriebsspannungsklemme (Vb, Masse) bzw. an einen Steueranschluß (S) angeschlossen sind und deren Drain-Source-Strecken die beiden Stromzweige (1, 2) verdinden, dadurch gekennzeichnet, daß die Gate-Elektroden sowohl des ersten als auch des zweiten MOS-Feldeffekttransistors (Q1, Q2) jeweils über einen Ladungsspeicherkondensator (C1, C2) an die Betriebspannungsklemme (Vb, Masse) angeschlossen ist.

2. MOS-Stromspiegel nach Anspruch 1, dadurch gekennzeichnet, daß im Eingangsstromzweig (1) ein mit den Drain-Source-Strecken der ersten MOS-Feldeffekttransistoren in Serie geschalteter, erster Widerstand (R1) vorgesehen ist, durch den ein konstanter Eingangsstrom (Ie) fließt, und daß im Ausgangsstromzweig (2) ein mit den Drain-Source-Strecken der zweiten MOS-Feldeffekttransistoren in Serie geschalteter, zweiter Widerstand (R2) vorgesehen ist, über den ein Ausgangsstrom (Ia) fließt, wenn am Steueranschluß (S) ein Steuersignal anliegt.

## Claims

1. Switchable MOS-current mirror comprising an input current branch (1) and an output current branch (2), the drain-source-path of a first and of a second MOS field effect transistor (Q1, Q2) being series connected in the input current branch (1) and the drain-source-path of a fifth and a sixth MOS field effect transistor (Q5, Q6) being series connected in the output current branch (2) and the gate electrode of the first MOS transistor (Q1) being connected to its drain electrode and to the gate electrode of the sixth MOS field effect transistor (Q6), and the gate electrode of the second MOS field effect transistor (Q2) being connected to its drain electrode and to the gate electrode of the fifth MOS field effect transistor (Q5), and a circuit part which includes a third and a fourth MOS field effect transistor (Q3, Q4, respectively), the gate electrodes of which are connected to an operating voltage terminal (Vb, ground) and to a control terminal (S), respectively, and the drain-source-paths of which connect the two current branches (1, 2) with each other, characterized in that the gate electrodes both of the first and of the second MOS field effect transistor (Q1, Q2) each are connected to the operating voltage terminal (Vb, ground) via a charge storing capacitor (C1, C2).

2. MOS-current mirror according to claim 1, characterized in that in the input current branch (1) a first resistor (R1) is provided series connected to the drain-source-path of the first MOS field effect transistors, a constant input current (Ie) flowing through that first resistor, and in that in the output current branch (2) a second resistor (R2) is provided series connected to the second field effect transistors, an output current (Ia) flowing through that second resistor when a control signal is applied to the control terminal (S).

## Revendications

1. Miroir de courant MOS commutable comportant une branche (1) pour le courant d'entrée et une branche (2) pour le courant de sortie, et dans lequel dans la branche (1) pour le courant d'entrée, les sections drain-source de premier et second transistors MOS à effet de champ (Q1,Q2) sont branchés en série et, dans la branche (2) pour le courant de sortie, les sections drain-source de cinquième et sixième transistors MOS à effet de champ (Q5,Q6) sont branchés en série, et dans lequel l'électrode de grille du premier transistor à effet de champ MOS (Q1) est reliée à son électrode de drain et à l'électrode de grille du sixième transistor MOS à effet de champ (Q6), l'électrode de grille du second transistor à effet de champ MOS (Q2) est reliée à son électrode de drain et l'électrode de grille du cinquième transistor MOS à effet de champ (Q5), et comportant une partie de circuit, qui comporte des troisième et quatrième transistors MOS à effet de champ (Q3 et Q4), dont les électrodes de grille sont raccordées respectivement à une borne de tension de service (Vb, masse) et à une borne de commande (S) et dont les sections drain-source relient les deux branches de courant (1,2), caractérisé en ce que les électrodes de grille aussi bien du premier que du second transistor à effet de champ MOS (Q1,Q2) sont raccordées respectivement à la borne de tension de service (Vb, masse) respectivement par l'intermédiaire d'un condensateur d'accumulation de charge (C1,C2).

2. Miroir de courant MOS selon la revendication 1, caractérisé en ce que dans la branche (1) pour le courant d'entrée est prévue une première résistance (R1), qui est branchée en série avec les voies drain-source des premiers transistors à effet de champ MOS et dans laquelle circule un courant d'entrée constant (Ie), et que dans la seconde branche (2) pour le courant de sortie est prévue une seconde résistance (R2), qui est branchée en série avec les voies drain-source des seconds transistors à effet de champ MOS et dans laquelle circule un courant de sortie (Ia) lorsqu'un signal de commande est appliqué à la borne de commande (S).

# Fig. 1

# Fig. 2

# Fig. 3

Fig. 4

# Fig. 5